# EUROPEAN PATENT SPECIFICATION

(11) **EP 3 499 654 B1**
(45) Date of publication and mention of the grant of the patent: **06.09.2023**
(21) Application number: 17207125.0
(22) Date of filing: 13.12.2017
(51) Int. Cl.: H01R 43/20, H01R 43/26

(54) **ELECTRICAL DISTRIBUTION ASSEMBLY**
STROMVERTEILUNGSANORDNUNG
ENSEMBLE DE DISTRIBUTION ÉLECTRIQUE

(43) Date of publication of application: 19.06.2019
(73) Proprietor: Aptiv Technologies Limited, St. Michael (BB)
(72) Inventor: GUILLANTON, Erwan, 28230 Epernon (FR); PEROT, Aymeric, 28230 Epernon (FR)
(74) Representative: INNOV-GROUP

(56) References cited:
- EP-A1- 0 649 028
- EP-A1- 1 030 411
- WO-A1-2006/131610
- US-A- 4 973 268

## Description

### TECHNICAL FIELD OF INVENTION

An electrical distribution assembly for distribution of high voltage in electrical or hybrid vehicles.

### BACKGROUND OF INVENTION

Electrical distribution assemblies for the distribution of electrical signals and electrical energy are well known in the art. These distribution assemblies use electrical connectors and electrical junction boxes, which are connected to each other. The electrical connectors usually comprise electrical terminals. The electrical terminals located inside the electrical connectors are attached on the ends of electrical wires. The junction boxes comprise bus bars to provide interconnection inside the junction boxes.

Some years ago the series production of vehicles having a hybrid or an electrical drive has started. This drive technology brought high voltages and high currents into customer vehicles. That increased the safety requirements enormously. For these reason e.g. electrical distribution assemblies have to be designed as one-way contactable system. That means, when the electrical connector is plugged to the junction box once, it can't be unplugged any more. If the electrical connector needs to be unplugged for any reason, it has to be destroyed.

Electrical harnesses, comprising electrical connectors and junction boxes, are preassembled in harness maker's plants and shipped to the vehicles makers. While shipping the preassembled electrical harnesses can be damaged or parts can be displaced. When finally assembled in the vehicle maker's plant, an undetected damage or displacement, can generate high costs for a fixation that s necessary afterwards. In case of a one-way connection especially missing or wrong electrical terminals cause big problems when the electrical connector is plugged once to the corresponding junction box.

EP 0 649 028 A1 discloses a connector assembly inspection device according to the preamble of claim 1. Further connector assemblies are disclosed in EP 1030 411 A1,US 4 973 268 A and WO 2006/131610A1.

Thus, there is the need in the art to provide an electrical distribution assembly for distribution of high voltage in electrical or hybrid vehicles, that overcomes the above-mentioned shortcomings of the prior art and provide an electrical distribution assembly that reliable prevent connecting of electrical connectors to electrical junction boxes when the electrical connector is not equipped with the necessary terminals on the correct positions.

An electrical distribution assembly according claim 1 solve these and other objects, which become apparent upon reading the following description.

### SUMMARY OF THE INVENTION

**The present disclosure provides an electrical distribution assembly according to claim 1, and an electrical wire harness according to claim 14. Advantageous features are provided in the dependent claims.**

The present application relates to an electrical distribution assembly for the distribution of high voltage in electrical or hybrid vehicles. The electrical distribution assembly comprising a junction box having a box housing. The box housing comprises a plug portion adapted to receive an electrical connector. The electrical connector of the electrical distribution assembly is having a connector housing, comprising a plurality of cavities, each adapted to receive and hold a terminal. The plug portion comprises a plurality of first blocking means protruding along a mating axis outwards the box housing. Each of the plurality of cavities comprises a second blocking means extending along the mating axis, along the cavity. Each of the first blocking means blocks the corresponding second blocking means in a blocked position when the corresponding cavity is empty, thereby preventing movement of the connector housing along the mating axis towards the box housing. The assembly further comprising at least one terminal movable from an outward position to an inserted position. Each terminal inserted in the cavity relocates the corresponding first blocking means or the corresponding second blocking means, to release the blocking, thereby allowing movement of the connector housing towards the box housing, along the mating axis.

The disclosed invention provides the opportunity to monitor each cavity of the electrical connector. Even only one missing or not proper inserted terminal blocks the connector wile mating to a junction box. Every single blocking means has to be released by the corresponding terminal. This functionality provides an electrical assembly that reliable prevent connecting of electrical connectors to electrical junction boxes when the electrical connector is not equipped with the necessary terminals on the correct positions.

According to a preferred embodiment, the first blocking means comprise a rigid lance and the second blocking means comprise a flexible arm. The flexible arm is flexible in a direction perpendicular to the mating axis. The flexible arm is bendable using little force what results in only little insertion force of the electrical connector towards the junction box.

Preferably, the rigid lance has a lance end and the flexible arm has an arm end. The lance end and the arm end are adapted to block each other, thereby preventing movement toward each other, in the blocked position. The arm end, as well as the lance end are adapted to press against each other along the mating axis, when the improper equipped connector is moved toward the electrical junction box. The simplest embodiment could be described as two flat surfaces on the two ends, arranged perpendicular to the mating axis.

Advantageously, the arm end has a release protrusion protruding inwards the cavity. The terminal comprises a terminal release surface. The terminal release surface displaces the arm end by urging against the release protrusion, when the terminal is received in the cavity, wherein the arm end is positioned in an unblocked position, allowing movement along the mating axis. Only a proper inserted Terminal unblock the corresponding blocking means.

Advantageously, the first blocking means comprise a flexible housing lance and wherein the second blocking means comprise a rigid cavity protrusion protruding perpendicular to the mating axis into the cavity. The flexible housing lance is flexible in a direction perpendicular to the mating axis. In this embodiment the flexible blocking means is arranged on the box housing, that provides advantages in some designs.

According to a preferred embodiment, the flexible housing lance has a housing lance end and the rigid cavity protrusion has a blocking edge. The housing lance end and the blocking edge are adapted to block each other, thereby preventing movement toward each other, in the blocked position. Dependent on the requirements the dimensions of the blocking means can be adapted to get robust properties.

Advantageously, the housing lance end has a housing lance release protrusion protruding, perpendicular to the mating axis towards the terminal and wherein the terminal comprises a terminal release surface, wherein the terminal release surface displaces the housing lance end by urging against the housing lance release protrusion when the terminal is received in the cavity, wherein the housing lance end is positioned in an unblocked position, allowing movement along the mating axis. The displaced housing lance end has a sloped area at the housing lance release protrusion that cooperates with a sloped area of the release protrusion. The housing lance release protrusion slides along the release protrusion while the electrical connector is moved along the mating axis towards the junction box. In the fully mated position the flexible housing lance is back in a relaxed position.

Preferably, movement of the connector housing toward the box, housing until a fully mated position, is only possible when all cavities of the connector housing are correct equipped with the intended terminals, whereby each terminal displaces each corresponding first blocking means. That makes sure that each cavity is correct equipped with a terminal.

Preferably the junction box comprises first final locking means and wherein the electrical connector comprises a second final locking means. The first final locking means and the second final locking means hold the junction box and the electrical connector inseparable together, when reached their fully mated position. That fulfils the safety requirements for high voltage applications in vehicles.

In a preferred embodiment, the junction box comprises a plurality of plug portion. The plurality of plug portions is electrically interconnected by a bus bar. That provides a robust design for high voltage and high power application.

In a preferred embodiment, the connector housing comprises a Guiding protrusion extending along the mating axis towards the plug portion and wherein the box housing comprises a guiding opening, adapted to receive the Guiding protrusion in the fully mated position. The guiding protrusion is inserted into the guiding opening at the beginning of the mating process of electrical connector an electrical junction box opening, guiding the electrical connector along the mating axis. That improves handling while assembly.

Preferably, the electrical distribution assembly is designed for high voltage application using voltages of about 400 Volt. To fulfil the requirements for high voltage application the dimensions and materials of the assembly are adapted.

Preferred, is an electrical wire harness comprising the distribution assembly and electrical wires attached on the terminals.

### Description of the preferred embodiments

In the following, the invention is described exemplarily with reference to the enclosed figures, in which
- Fig. 1: shows a perspective, view to an electrical distribution assembly for the distribution of high voltage in electrical or hybrid vehicles;
- Fig. 2: shows a cut view of an electrical distribution assembly known from prior art;
- Fig. 3: shows a cut view of an electrical distribution assembly along cut line C, with an empty cavity;
- Fig. 4: shows details of figure 3;
- Fig. 5: shows a cut view of an electrical distribution assembly along cut line C with enlarged details in an unblocked position;
- Fig. 6: shows a cut view of an electrical distribution assembly along cut line C with enlarged details in a fully mated position;
- Fig. 7: shows a cut view of a second embodiment of an electrical distribution assembly along cut line C with enlarged details in an unblocked position;
- Fig. 8: shows a cut view of a second embodiment of an electrical distribution assembly along cut line C with enlarged details in a fully mated position;

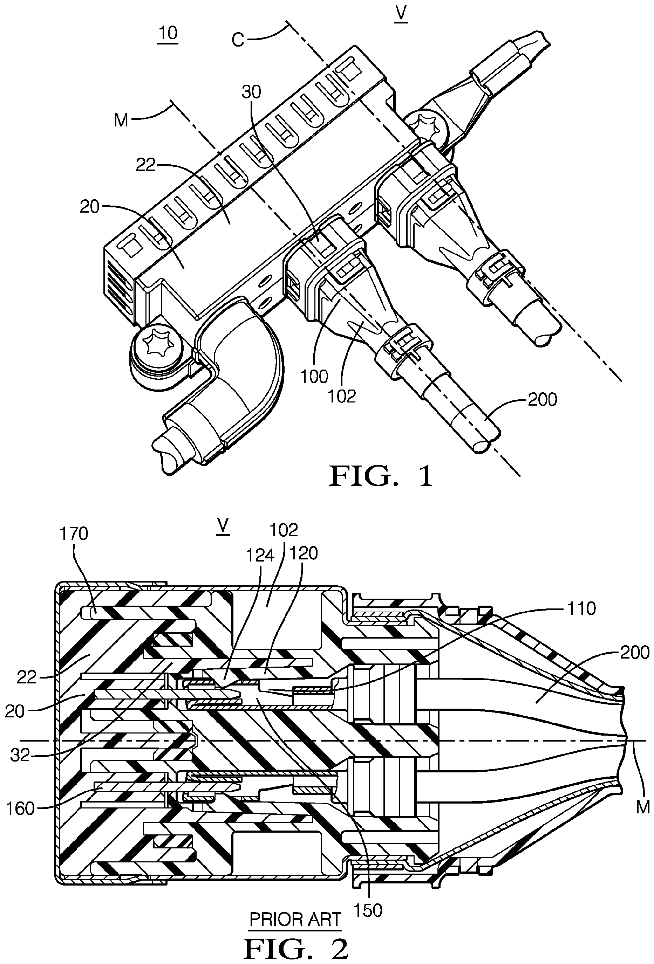

Figure 1 shows a perspective, view to an electrical distribution assembly 10 for the distribution of high voltage in electrical or hybrid vehicles. The assembly shows also electrical wires 200 attached on electrical terminals 150 (not shown) defining a wire harness. The electrical distribution assembly comprising a junction box 20 having a box housing 22. The box housing 22 comprises a plug portion 30 adapted to receive an electrical connector 100. The electrical connector 100 of the electrical distribution assembly is having a connector housing 102. The electrical connectors are arranged along a mating axis M.

Figure 2 shows a cut view of an electrical distribution assembly known from prior art. The electrical distribution assembly comprises a junction box 20 having a box housing 22. The box housing 22 comprises a plug portion 30 adapted to receive an electrical connector 100. The electrical connector 100 of the electrical distribution assembly is having a connector housing 102. The electrical connector 100 is plugged along a mating axis M. The electrical connector 100 comprising a plurality of cavities 110, each adapted to receive and hold a terminal 150. Each cavity 110 comprise a flexible arm 120 having an arm end 124. The arm end 124 comprises a terminal locking protrusion, adapted to lock the terminal in the cavity 110 when the electrical connector 100 is in the fully mated position V.

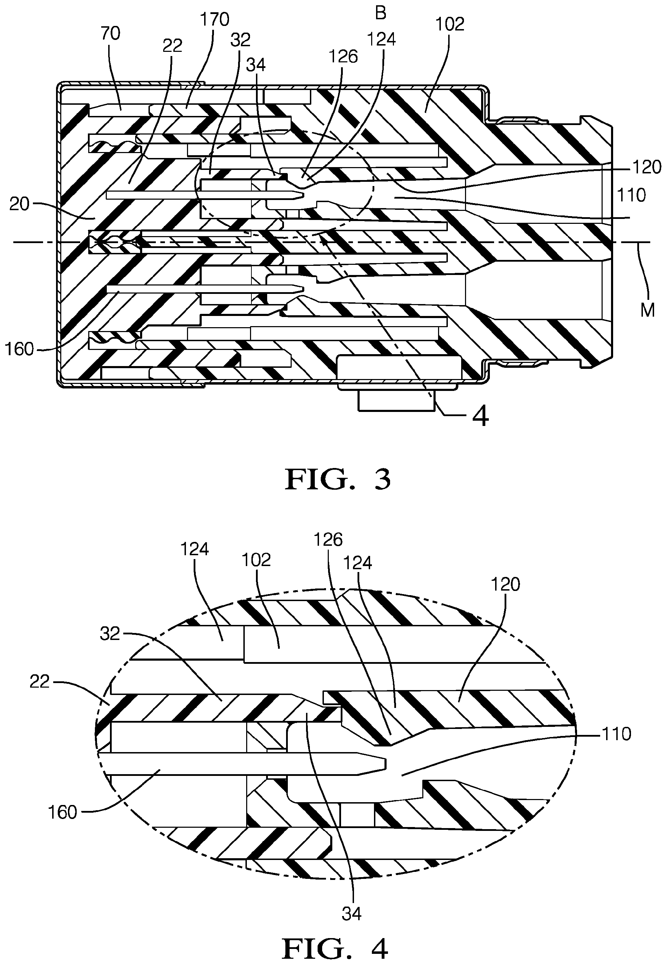

Figure 3 shows a cut view of an inventive electrical distribution assembly 10 whereby the cut is carried out along cut line C. The electrical distribution assembly 10 is shown in a blocked position B with an empty cavity 110. The electrical distribution assembly 10 comprises a junction box 20 having a box housing 22. The box housing 22 comprises a plug portion 30 adapted to receive an electrical connector 100. The electrical connector 100 of the electrical distribution assembly is having a connector housing 102. The electrical connector 100 is plugged along a mating axis M. The electrical connector 100 comprising a plurality of cavities 110, each adapted to receive and hold a terminal 150. The plug portion 30 comprises a plurality of first blocking means protruding along a mating axis M outwards the box housing 22. Each of the plurality of cavities 110 comprises a second blocking means extending along the mating axis M, along the cavity 110. Each of the first blocking means blocks the corresponding second blocking means in the blocked position B when the corresponding cavity is empty, thereby preventing movement of the connector housing 102 along the mating axis M towards the box housing 22. The connector housing 102 comprises a guiding protrusion 170 extending towards the plug portion 30.The box housing 22 comprises a guiding opening 70, adapted to receive the Guiding protrusion 170 in the fully mated position V.

Figure 4 shows details of figure 3. The first blocking means comprise a rigid lance 32 and the second blocking means comprise a flexible arm 120. The flexible arm 120 is flexible in a direction perpendicular to the mating axis M. The rigid lance 32 has a lance end 34 and the flexible arm 120 has an arm end 124 The lance end 34 and the arm end 124 are adapted to block each other, thereby preventing movement toward each other, in the blocked position B

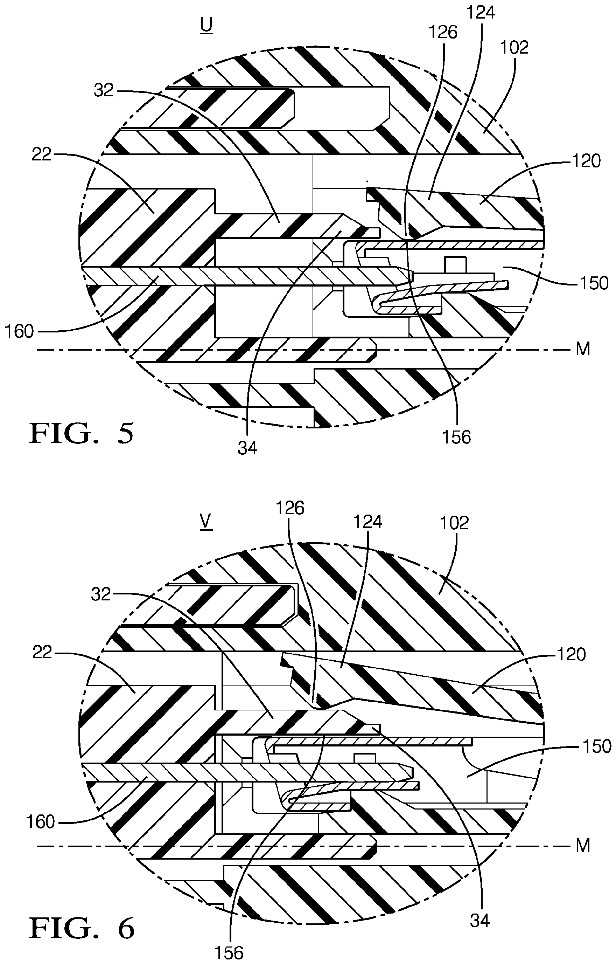

Figure 5 shows a cut view of an electrical distribution assembly 10 along cut line C, with enlarged details in an unblocked position U. The assembly 10 further comprising at least one terminal 150 movable from an outward position to an inserted position. The junction box 20 comprises a plurality of plug portion 30, wherein the plurality of plug portions 30 are electrically interconnected by a bus bar 160. Each terminal 150 inserted in the cavity 110 relocates the corresponding first blocking means or the corresponding second blocking means, to release the blocking, thereby allowing movement of the connector housing 102 towards the box housing 22, along the mating axis M. The arm end 124 has a release protrusion 126 protruding inwards the cavity 110. The terminal 150 comprises a terminal release surface 156. The terminal release surface 156 displaces the arm end 124 by urging against the release protrusion 126 when the terminal is received in the cavity 110. The arm end 124 is positioned in an unblocked position U, allowing movement along the mating axis M.

Figure 6 shows a cut view of an electrical distribution assembly 10 along cut line C with enlarged details in a fully mated position V. Movement of the connector housing 102 toward the box housing 22 until the fully mated position V is only possible when all cavities 110 of the connector housing 102 are correct equipped with the intended terminals 150, whereby each terminal 150 displace each corresponding first blocking means.

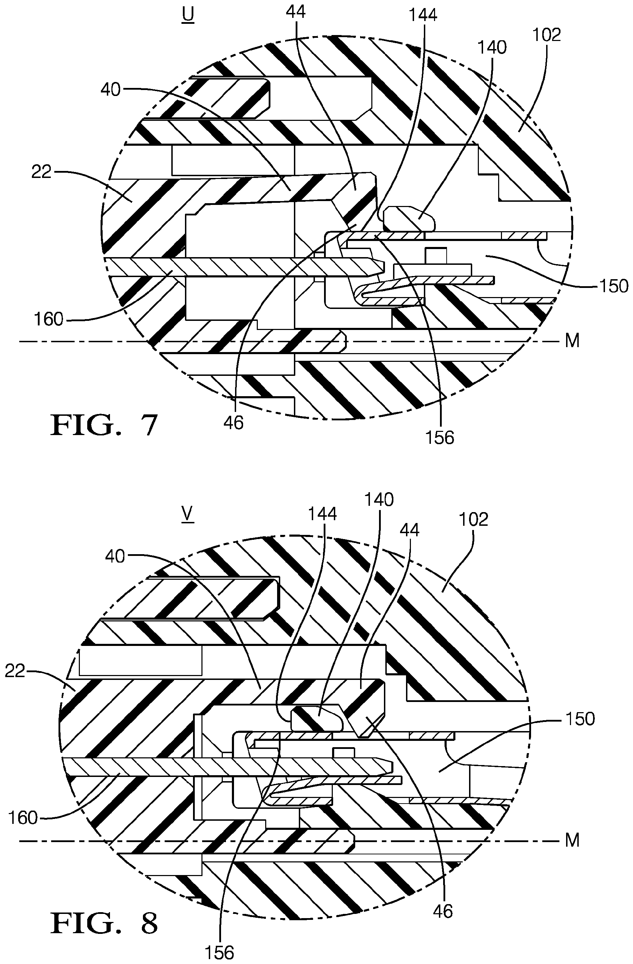

Figure 7 shows a cut view of a second embodiment of an electrical distribution assembly 10 along cut line C, with enlarged details in an unblocked position U. The first blocking means comprise a flexible housing lance 40 and the second blocking means comprise a rigid cavity protrusion 140 protruding perpendicular to the mating axis M into the cavity 110. The flexible housing lance 40 is flexible in a direction perpendicular to the mating axis M. The flexible housing lance 40 has a housing lance end 44 and the rigid cavity protrusion 140 has a blocking edge 144. The housing lance end 44 and the blocking edge 144 are adapted to block each other, thereby preventing movement toward each other, in the blocked position B. The housing lance end 44 has a housing lance release protrusion 46 protruding, perpendicular to the mating axis M, towards the terminal 150. The terminal comprises a terminal release surface 156. The terminal release surface 156 displaces the housing lance end 44 by urging against the housing lance release protrusion 46 when the terminal is received in the cavity 110. The housing lance end 44 is positioned in an unblocked position U, allowing movement along the mating axis M.

Figure 8 shows a cut view of a second embodiment of an electrical distribution assembly along cut line C with enlarged details in a fully mated position. Movement of the connector housing 102 toward the box housing 22 until the fully mated position V is only possible when all cavities 110 of the connector housing 102 are correct equipped with the intended terminals 150, whereby each terminal 150 displace each corresponding first blocking means. In this embodiment, the first blocking means and the second blocking means are in a relaxed position when the electrical connector 100 reached his fully mated position V.

## Claims

1. An electrical distribution assembly (10) for the distribution of high voltage in electrical or hybrid vehicles, comprising: a junction box (20) having a box housing (22) comprising a plug portion (30) adapted to receive an electrical connector (100) which is a part of the electrical distribution assembly (10); the electrical connector (100) having a connector housing (102) comprising a plurality of cavities (110) each adapted to receive and hold a terminal (150) of the electrical connector (100), wherein the plug portion (30) comprises a plurality of first blocking means protruding along a mating axis (M) outwards the box housing (22), **characterized in that** each of the plurality of cavities (110) comprises a second blocking means extending along the mating axis (M) along the cavity (110), wherein each of the first blocking means blocks the corresponding second blocking means in a blocked position (B) when the corresponding cavity (110) is empty, thereby preventing movement of the connector housing (102) along the mating axis (M) towards the box housing (22).

2. An electrical distribution assembly according to claim 1, further comprising at least one terminal (150) movable from an outward position to an inserted position, wherein each terminal (150) inserted in the cavity (110) relocates the corresponding first blocking means or the corresponding second blocking means, to release the blocking, thereby allowing movement of the connector housing (102) towards the box housing (22), along the mating axis (M).

3. An electrical distribution assembly (10) according to claim 2, wherein the first blocking means comprise a rigid lance (32) and wherein the second blocking means comprise a flexible arm (120), wherein the flexible arm (120) is flexible in a direction perpendicular to the mating axis (M).

4. An electrical distribution assembly (10) according to the preceding claim, wherein the rigid lance (32) has a lance end (34) and wherein the flexible arm (120) has an arm end (124), wherein the lance end (34) and the arm end (124) are adapted to block each other, thereby preventing movement toward each other, in the blocked position (B).

5. An electrical distribution assembly (10) according to the preceding claim wherein the arm end (124) has a release protrusion (126) protruding inwards the cavity (110) and wherein the terminal (150) comprises a terminal release surface (156), wherein the terminal release surface (156) displaces the arm end (124) by urging against the release protrusion (126) when the terminal is received in the cavity (110), wherein the arm end (124) is positioned in an unblocked position (U), allowing movement along the mating axis (M).

6. An electrical distribution assembly (10) according to claim 2, wherein the first blocking means comprise a flexible housing lance (40) and wherein the second blocking means comprise a rigid cavity protrusion (140) protruding perpendicular to the mating axis (M) into the cavity (110), wherein the flexible housing lance (40) is flexible in a direction perpendicular to the mating axis (M).

7. An electrical distribution assembly (10) according to the preceding claim, wherein the flexible housing lance (40) has a housing lance end (44) and wherein the rigid cavity protrusion (140) has a blocking edge (144), wherein the housing lance end (44) and the blocking edge (144) are adapted to block each other, thereby preventing movement toward each other, in the blocked position (B).

8. An electrical distribution assembly (10) according to the preceding claim wherein the housing lance end (44) has a housing lance release protrusion (46) protruding, perpendicular to the mating axis (M) towards the terminal (150) and wherein the terminal comprises a terminal release surface (156), wherein the terminal release surface (156) displaces the housing lance end (44) by urging against the housing lance release protrusion (46) when the terminal is received in the cavity (110), wherein the housing lance end (44) is positioned in an unblocked position (U), allowing movement along the mating axis (M).

9. An electrical distribution assembly (10) according to any preceding claim, wherein movement of the connector housing (102) toward the box housing (22) until a fully mated position (V) is only possible when all cavities (110) of the connector housing (102) are correct equipped with the intended terminals (150), whereby each terminal (150) displaces each corresponding first blocking means.

10. An electrical distribution assembly (10) according to the preceding claim, wherein the junction box (20) comprises first final locking means and wherein the electrical connector (100) comprises a second final locking means, wherein the first final locking means and the second final locking means hold the junction box (20) and the electrical connector (100) inseparable together, when reached their fully mated position (V).

11. An electrical distribution assembly (10) according to the preceding claim, wherein the junction box (20) comprises a plurality of plug portion (30), wherein the plurality of plug portions (30) are electrically interconnected by a bus bar (160).

12. An electrical distribution assembly (10) according to any of the claims 2-11, wherein the electrical distribution assembly is designed for high voltage application using voltages of about 400 Volt.

13. An electrical distribution assembly (10) according to any of the claims 2-12 wherein the connector housing (102) comprises a Guiding protrusion (170) extending towards the plug portion (30) and wherein the box housing (22) comprises a guiding opening (70), adapted to receive the Guiding protrusion (170) in the fully mated position (V).

14. An electrical wire harness comprising the distribution assembly (10) according to any of claims 2 to 13, comprising electrical wires (200) attached on the terminals (150).

## Patentansprüche

1. Stromverteilungsanordnung (10) für die Verteilung von Hochspannung in Elektro-oder Hybridfahrzeugen, aufweisend: eine Anschlussdose (20) mit einem Schaltasten (22), der einen Steckerabschnitt (30) aufweist, der zur Aufnahme eines elektrischen Steckverbinders (100) geeignet ist, der Teil der Stromverteilungsanordnung (10) ist; wobei der elektrische Steckverbinder (100) ein Steckverbindergehäuse (102) aufweist, das mehrere Hohlräume (110) aufweist, die jeweils dazu geeignet sind, einen Anschluss (150) des elektrischen Steckverbinders (100) aufzunehmen und zu halten, wobei der Steckerabschnitt (30) mehrere erste Blockiereinrichtungen aufweist, die entlang einer Steckachse (M) aus dem Schaltkasten (22) herausragen,
**dadurch gekennzeichnet, dass** jeder der mehreren Hohlräume (110) eine zweite Blockiereinrichtung aufweist, die sich entlang der Steckachse (M) entlang des Hohlraums (110) erstreckt, wobei jede der ersten Blockiereinrichtungen die entsprechende zweite Blockiereinrichtung in einer Blockierposition (B) blockiert, wenn der entsprechende Hohlraum (110) leer ist, wodurch eine Bewegung des Steckergehäuses (102) entlang der Steckachse (M) in Richtung des Schaltkastens (22) verhindert wird.

2. Stromverteilungsanordnung nach Anspruch 1, ferner aufweisend mindestens einen Anschluss (150), der von einer äußeren Position in eine eingeführte Position bewegbar ist, wobei jeder in den Hohlraum (110) eingeführte Anschluss (150) die entsprechende erste Blockiereinrichtung oder die entsprechende zweite Blockiereinrichtung neu positioniert, um die Blockierung aufzuheben, wodurch eine Bewegung des Steckergehäuses (102) in Richtung des Schaltkastens (22) entlang der Steckachse (M) ermöglicht wird.

3. Stromverteilungsanordnung (10) nach Anspruch 2,
wobei die ersten Blockiereinrichtungen eine Starrlanze (32) aufweisen und wobei die zweiten Blockiereinrichtungen einen flexiblen Arm (120) aufweisen, wobei der flexible Arm (120) in einer Richtung senkrecht zu der Steckachse (M) flexibel ist.

4. Stromverteilungsanordnung (10) nach dem vorhergehenden Anspruch, wobei die Starrlanze (32) ein Lanzenende (34) aufweist und wobei der flexible Arm (120) ein Armende (124) aufweist, wobei das Lanzenende (34) und das Armende (124) dazu ausgelegt sind, sich gegenseitig zu blockieren und dadurch eine Bewegung zueinander in der blockierten Position (B) zu verhindern.

5. Stromverteilungsanordnung (10) nach dem vorhergehenden Anspruch, wobei das Armende (124) einen Freigabevorsprung (126) aufweist, der in den Hohlraum (110) hineinragt, und wobei der Anschluss (150) eine Anschlussfreigabefläche (156) aufweist, wobei die Anschlussfreigabefläche (156) das Armende (124) verschiebt, indem sie gegen den Freigabevorsprung (126) drückt, wenn der Anschluss in dem Hohlraum (110) aufgenommen wird, wobei das Armende (124) in einer nicht blockierten Position (U) positioniert wird, die eine Bewegung entlang der Steckachse (M) ermöglicht.

6. Stromverteilungsanordnung (10) nach Anspruch 2,
wobei die ersten Blockiereinrichtungen eine flexible Gehäuselanze (40) aufweisen und wobei die zweiten Blockiereinrichtungen einen starren Hohlraumvorsprung (140) aufweisen, der senkrecht zu der Steckachse (M) in den Hohlraum (10) hineinragt, wobei die flexible Gehäuselanze (40) in einer Richtung senkrecht zu der Steckachse (M) flexibel ist.

7. Stromverteilungsanordnung (10) nach dem vorhergehenden Anspruch, wobei die flexible Gehäuselanze (40) ein Gehäuselanzenende (44) aufweist und wobei der starre Hohlraumvorsprung (140) eine Blockierkante (144) aufweist, wobei das Gehäuselanzenende (44) und die Blockierkante (144) dazu ausgelegt sind, einander zu blockieren und dadurch in der Blockierposition (B) eine Bewegung zueinander zu verhindern.

8. Stromverteilungsanordnung (10) nach dem vorhergehenden Anspruch, wobei das Gehäuselanzenende (44) einen Gehäuselanzenfreigabevorsprung (46) aufweist, der senkrecht zu der Steckachse (M) in Richtung des Anschlusses (150) vorsteht, und wobei der Anschluss eine Anschlussfreigabefläche (156) aufweist, wobei die Anschlussfreigabefläche (156) das Gehäuselanzenende (44) verschiebt, indem sie gegen den Gehäuselanzenfreigabevorsprung (46) drückt, wenn der Anschluss in dem Hohlraum (110) aufgenommen wird, wobei das Gehäuselanzenende (44) in einer nicht blockierten Position (U) positioniert ist, was eine Bewegung entlang der Passachse (M) ermöglicht.

9. Stromverteilungsanordnung (10) nach einem der vorhergehenden Ansprüche, wobei eine Bewegung des Steckergehäuses (102) in Richtung des Schaltkastens (22) bis zu einer vollständig zusammengesteckten Position (V) nur möglich ist, wenn alle Hohlräume (110) des Steckergehäuses (102) korrekt mit den vorgesehenen Anschlüssen (150) ausgestattet sind, wobei jeder Anschluss (150) jede entsprechende erste Blockiereinrichtung verschiebt.

10. Stromverteilungsanordnung (10) nach dem vorhergehenden Anspruch, wobei die Anschlussdose (20) eine erste finale Verriegelungseinrichtung aufweist und wobei der elektrische Steckverbinder (100) eine zweite finale Verriegelungseinrichtung aufweist, wobei die erste finale Verriegelungseinrichtung und die zweite finale Verriegelungseinrichtung die Anschlussdose (20) und den elektrischen Steckverbinder (100) untrennbar zusammenhalten, wenn ihre vollständig zusammengesteckte Position (V) erreicht ist.

11. Stromverteilungsanordnung (10) nach dem vorhergehenden Anspruch, wobei die Anschlussdose (20) mehrere Steckerabschnitte (30) aufweist, wobei die mehreren Steckerabschnitte (30) durch eine Sammelschiene (160) elektrisch miteinander verbunden sind.

12. Stromverteilungsanordnung (10) nach einem der Ansprüche 2-11,
wobei die Stromverteilungsanordnung für Hochspannungsanwendungen mit Spannungen von etwa 400 Volt ausgelegt ist.

13. Stromverteilungsanordnung (10) nach einem der Ansprüche 2-12,
wobei das Steckergehäuse (102) einen Führungsvorsprung (170) aufweist, der sich in Richtung des Steckerabschnitts (30) erstreckt, und wobei der Schaltkasten (22) eine Führungsöffnung (70) aufweist, die angepasst ist, um den Führungsvorsprung (170) in der vollständig zusammengesteckten Position (V) aufzunehmen.

14. Elektrischer Kabelbaum, aufweisend die Verteilungsanordnung (10) nach einem der Ansprüche 2 bis 13, aufweisend elektrische Drähte (200), die an den Anschlüssen (150) befestigt sind.

## Revendications

1. Ensemble de distribution électrique (10) pour la distribution d'une tension élevée dans les véhicules électriques ou hybrides, comprenant : une boîte de jonction (20) comportant un logement de boîte (22) comprenant une partie de prise mâle (30) adaptée pour recevoir un connecteur électrique (100) qui est une partie de l'ensemble de distribution électrique (10) ; le connecteur électrique (100) comportant un logement de connecteur (102) comprenant une pluralité de cavités (110) dont chacune est adaptée pour recevoir et maintenir une borne (150) du connecteur électrique (100), dans lequel la partie de prise mâle (30) comprend une pluralité de premiers moyens de blocage faisant saillie suivant un axe d'accouplement (M) à l'extérieur du logement de boîte (22),
**caractérisé en ce que** chacune de la pluralité de cavités (110) comprend des seconds moyens de blocage étendus suivant l'axe d'accouplement (M) le long de la cavité (110), dans lequel chacun des premiers moyens de blocage bloque le second moyen de blocage correspondant dans une position bloquée (B) lorsque la cavité correspondante (110) est vide, ce qui empêche le déplacement du logement de connecteur (102) suivant l'axe d'accouplement (M) en direction du logement de boîte (22).

2. Ensemble de distribution électrique selon la revendication 1, comprenant en outre au moins une borne (150) qui peut être déplacée depuis une position à l'extérieur jusqu'à une position insérée, dans lequel chaque borne (150) insérée dans la cavité (110) repositionne le premier moyen de blocage correspondant ou le second moyen de blocage correspondant, pour libérer le blocage, ce qui permet le déplacement du logement de connecteur (102) en direction du logement de boîte (22), suivant l'axe d'accouplement (M).

3. Ensemble de distribution électrique (10) selon la revendication 2, dans lequel les premiers moyens de blocage comprennent une lance rigide (32) et dans lequel les seconds moyens de blocage comprennent un bras flexible (120), dans lequel le bras flexible (120) est flexible dans une direction perpendiculaire à l'axe d'accouplement (M).

4. Ensemble de distribution électrique (10) selon la revendication précédente, dans lequel la lance rigide (32) comporte une extrémité de lance (34) et dans lequel le bras flexible (120) comporte une extrémité de bras (124), dans lequel l'extrémité de lance (34) et l'extrémité de bras (124) sont adaptées pour être mutuellement bloquées, ce qui empêche leur rapprochement, dans la position bloquée (B).

5. Ensemble de distribution électrique (10) selon la revendication précédente, dans lequel l'extrémité de bras (124) comporte une protubérance de libération (126) qui fait saillie à l'intérieur de la cavité (110) et dans lequel la borne (150) comprend une surface de libération de borne (156), dans lequel la surface de libération de borne (156) déplace l'extrémité de bras (124) en exerçant une poussée contre la protubérance de libération (126) lorsque la borne est reçue dans la cavité (110), dans lequel l'extrémité de bras (124) est positionnée dans une position non bloquée (U), ce qui permet le déplacement suivant l'axe d'accouplement (M).

6. Ensemble de distribution électrique (10) selon la revendication 2, dans lequel les premiers moyens de blocage comprennent une lance de logement flexible (40) et dans lequel les seconds moyens de blocage comprennent une protubérance de cavité rigide (140) qui fait saillie perpendiculairement à l'axe d'accouplement (M) à l'intérieur de la cavité (110), dans lequel la lance de logement flexible (40) est flexible dans une direction perpendiculaire à l'axe d'accouplement (M).

7. Ensemble de distribution électrique (10) selon la revendication précédente, dans lequel la lance de logement flexible (40) comporte une extrémité de lance de logement (44) et dans lequel la protubérance de cavité rigide (140) comporte un bord de blocage (144), dans lequel l'extrémité de lance de logement (44) et le bord de blocage (144) sont adaptés pour être mutuellement bloqués, ce qui empêche leur rapprochement, dans la position bloquée (B).

8. Ensemble de distribution électrique (10) selon la revendication précédente, dans lequel l'extrémité de lance de logement (44) comporte une protubérance de libération de lance de logement (46) qui fait saillie, perpendiculairement à l'axe d'accouplement (M), en direction de la borne (150) et dans lequel la borne comprend une surface de libération de borne (156), dans lequel la surface de libération de borne (156) déplace l'extrémité de lance de logement (44) en exerçant une poussée contre la protubérance de libération de lance de logement (46) lorsque la borne est reçue dans la cavité (110), dans lequel l'extrémité de lance de logement (44) est positionnée dans une position non bloquée (U), ce qui permet un déplacement suivant l'axe d'accouplement (M).

9. Ensemble de distribution électrique (10) selon l'une quelconque des revendications précédentes, dans lequel le déplacement du logement de connecteur (102) en direction du logement de boîte (22) jusqu'à une position complètement accouplée (V) est seulement possible lorsque toutes les cavités (110) du logement de connecteur (102) sont munies correctement des bornes (150) qui leur sont destinées, d'où il résuite que chaque borne (150) déplace chaque premier moyen de blocage correspondant.

10. Ensemble de distribution électrique (10) selon la revendication précédente, dans lequel la boîte de jonction (20) comprend un premier moyen de verrouillage final et dans lequel le connecteur électrique (100) comprend un second moyen de verrouillage final, dans lequel le premier moyen de verrouillage final et le second moyen de verrouillage final maintiennent la boîte de jonction (20) et le connecteur électrique (100) ensemble de façon non séparable, lorsqu'ils ont atteint leur position complètement accouplée (V).

11. Ensemble de distribution électrique (10) selon la revendication précédente, dans lequel la boîte de jonction (20) comprend une pluralité de parties de prise mâle (30), dans lequel les parties de prise mâle de la pluralité de parties de prise mâle (30) sont interconnectées électriquement par un busbar (160).

12. Ensemble de distribution électrique (10) selon l'une quelconque des revendications 2 à 11, dans lequel l'ensemble de distribution électrique est conçu pour une application à tension élevée utilisant des tensions d'environ 400 Volts.

13. Ensemble de distribution électrique (10) selon l'une quelconque des revendications 2 à 12, dans lequel le logement de connecteur (102) comprend une protubérance de guidage (170) qui est étendue en direction de la partie de prise mâle (30) et dans lequel le logement de boîte (22) comprend une ouverture de guidage (70) qui est adaptée pour recevoir la protubérance de guidage (170) dans la position complètement accouplée (V).

14. Harnais de fils électriques comprenant l'ensemble de distribution (10) selon l'une quelconque des revendications 2 à 13, comprenant des fils électriques (200) qui sont liés sur les bornes (150).
